(19) Europäisches Patentamt European Patent Office Office européen des brevets

(11) **EP 4 718 731 A1**

(12) **EUROPEAN PATENT APPLICATION**
published in accordance with Art. 153(4) EPC

(43) Date of publication:
01.04.2026 Bulletin 2026/14

(21) Application number: 24830409.9

(22) Date of filing: 03.06.2024

(51) International Patent Classification (IPC):
*H03M 13/11* (2006.01)

(52) Cooperative Patent Classification (CPC):
H03M 13/11

(86) International application number:
PCT/CN2024/097094

(87) International publication number:
WO 2025/001762 (02.01.2025 Gazette 2025/01)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 26.06.2023 CN 202310762257
14.08.2023 CN 202311020949

(71) Applicant: Huawei Technologies Co., Ltd.
Shenzhen, Guangdong 518129 (CN)
(72) Inventors:
• YANG, Rui
  Shenzhen, Guangdong 518129 (CN)
• WANG, Sihai
  Shenzhen, Guangdong 518129 (CN)
• QIN, Cheng
  Shenzhen, Guangdong 518129 (CN)
• LI, Xueru
  Shenzhen, Guangdong 518129 (CN)

(74) Representative: Pfenning, Meinig & Partner mbB
Patent- und Rechtsanwälte
Theresienhöhe 11a
80339 München (DE)

(54) **DECODING METHOD AND APPARATUS, AND PARAMETER TRAINING METHOD AND APPARATUS**

(57) This application relates to a decoding method, a parameter training method, and an apparatus. A first sequence is received, one set of weights is determined from at least one set of weights based on a parameter of the first sequence, where the at least one set of weights is determined through training, the one set of weights includes a weight corresponding to K iterations of decoding performed on the first sequence, there are at least two different weights in the one set of weights, a quantity of weights corresponding to one iteration of decoding in the K iterations of decoding is greater than or equal to 1; and in a process of performing the one iteration of decoding in the K iterations of decoding on the first sequence, based on the weight corresponding to the one iteration of decoding, information about N variable nodes and information about M check nodes corresponding to the first sequence are determined. In embodiments of this application, corresponding weights may be applied to different calculation processes during decoding, making the weights better match the corresponding calculation processes. Therefore, decoding flexibility is improved, and decoding performance is enhanced.

FIG. 2

**Description**

CROSS-REFERENCE TO RELATED APPLICATIONS

This application claims priorities to Chinese Patent Application No. 202310762257.X, filed with the China National Intellectual Property Administration on June 26, 2023 and entitled "CHANNEL DECODING METHOD AND DECODING CIRCUIT", and to Chinese Patent Application No. 202311020949.3, filed with the China National Intellectual Property Administration on August 14, 2023 and entitled "DECODING METHOD, PARAMETER TRAINING METHOD, AND APPARATUS", both of which are incorporated herein by reference in their entireties.

TECHNICAL FIELD

This application relates to the field of communication technologies, and in particular, to a decoding method, a parameter training method, and an apparatus.

BACKGROUND

Low density parity check (low density parity check, LDPC) codes are a type of linear block codes with a sparse parity check matrix, featuring flexible structures and low decoding complexity. Because the LDPC codes use partially parallel iterative decoding algorithms, they achieve higher throughputs than conventional Turbo codes. The LDPC codes may be used as errorcorrecting codes in communication systems, to improve channel transmission reliability and power utilization. Additionally, the LDPC codes can be widely used in space communication, optical fiber communication, personal communication systems, asymmetric digital subscriber lines (asymmetric digital subscriber line, ADSL), magnetic recording devices, or the like. Currently, the LDPC codes have been considered as one of channel encoding/decoding schemes in the $5^{th}$ generation (the $5^{th}$ generation, 5G) mobile communication.

There are a plurality of encoding/decoding schemes for LDPC. A process of belief propagation (belief propagation, BP) decoding in the plurality of encoding/decoding schemes is essentially a process of iteratively transferring belief information between a variable node and a check node in an LDPC check matrix. BP decoding may undergo multiple iterations. In a single iteration, information about each variable node and information about each check node in the LDPC check matrix are calculated. The calculation process is complex, which imposes high requirements on performance of a decoding apparatus and may also cause low decoding efficiency.

SUMMARY

Embodiments of this application provide a decoding method, a parameter training method, and an apparatus, to reduce LDPC decoding complexity and improve LDPC decoding performance.

According to a first aspect, a first decoding method is provided. For example, the decoding method is a channel decoding method. The method may be performed by a second apparatus, or may be performed by another device including a decoding function, or may be performed by a chip system (or a chip) or another functional module. The chip system or the functional module can implement a function of the second apparatus. The chip system or the functional module is, for example, disposed in the second apparatus. The second apparatus may also be referred to as, for example, a decoding apparatus. The second apparatus may be a network device or a terminal device, or the second apparatus may be disposed in the network device or the terminal device. The method includes: receiving a first sequence; determining one set of weights from at least one set of weights based on a parameter of the first sequence, where the at least one set of weights is determined through training, the one set of weights includes a weight corresponding to K iterations of decoding performed on the first sequence, there are at least two different weights in the one set of weights, a quantity of weights corresponding to one iteration of decoding in the K iterations of decoding is greater than or equal to 1, and K is a positive integer less than or equal to a maximum quantity of iterations of decoding; and in a process of performing the one iteration of decoding in the K iterations of decoding on the first sequence, determining, based on the weight corresponding to the one iteration of decoding, information about N variable nodes and information about M check nodes corresponding to the first sequence, where both M and N are positive integers.

In embodiments of this application, information about a variable node and information about a check node may be determined based on weights, and this is equivalent to adding the weight as compensation. Therefore, calculation complexity can be reduced, and performance requirements on the decoding apparatus can be lowered, making the technical solutions in embodiments of this application more widely applicable. In addition, in embodiments of this application, the at least one set of weights may be obtained through training. If a quantity of the at least one set is greater than 1, one set of weights in the at least one set of weights may be used in one round of decoding process (including multiple iterations of decoding), and different sets of weights may be used in different rounds of decoding processes. In different iterative decoding processes in one round of decoding process, different weights in one set of weights may also be used. In addition, if a quantity of weights corresponding to one iteration of decoding is greater than 1, different weights may also be used for different calculations even in a process of one iteration of decoding. It can be learned that in embodiments of this application, corresponding weights may be applied to different calculation processes during decoding, making the weights better match the corresponding calculation processes. Therefore, decoding flexibility is improved, and decoding performance is enhanced.

In an optional implementation, the weight corresponding to the one iteration of decoding includes a first weight, the first weight is used to determine information about a first connection, and the first connection is a connection between one check node in the M check nodes and one variable node in the N variable nodes, where when the first weight is less than a first threshold, information about the one check node or information about the one variable node does not include the information about the first connection. If a weight used to calculate information about a specific connection is less than the first threshold, the connection may be less effective. Therefore, the information about the connection may not need to be calculated, thereby reducing a calculation amount and reducing decoding complexity. The first threshold is, for example, 0.05, or may be another value.

In an optional implementation, in the process of the one iteration of decoding, the information about the N variable nodes and the information about the M check nodes are determined in a serial manner; or the N variable nodes and the M check nodes belong to at least one group, each group includes one or more variable nodes in the N variable nodes and/or includes one or more check nodes in the M check nodes, and in the process of the one iteration of decoding, processing for any two groups in the at least one group is performed in a parallel manner, where when processing for one group is performed, information about a variable node and/or information about a check node in the group is determined in a serial manner. In the process of the one iteration of decoding, calculation processes between any two groups in the at least one group may be performed in a parallel manner, and a calculation process in one group may be performed in a serial manner. Due to parallel processing between groups, decoding efficiency is improved, and an iterative convergence speed is increased.

In an optional implementation, the at least one group is determined based on an LDPC check matrix, and each group in the at least one group includes one or more rows of the LDPC check matrix, or includes one or more columns of the LDPC check matrix, where one row of the LDPC check matrix corresponds to one check node in the M check nodes, and one column of the LDPC check matrix corresponds to one variable node in the N variable nodes. A grouping manner is provided, that is, grouping is implemented based on the LDPC check matrix. In addition, another manner may alternatively be used for grouping, and this is not limited.

In an optional implementation, the method further includes: when a result of decision performed on the one iteration of decoding is 0, outputting the result of the one iteration of decoding, and ending the decoding; or when a result of decision performed on the one iteration of decoding is not 0, performing a next iteration of decoding in the K iterations of decoding on the first sequence.

According to a second aspect, a parameter training method is provided. The method may be performed by a third apparatus, or may be performed by another device including a parameter training function, or may be performed by a chip system (or a chip) or another functional module. The chip system or the functional module can implement a function of the third apparatus. The chip system or the functional module is, for example, disposed in the third apparatus. The third apparatus may also be referred to as a decoding apparatus, for example. The third apparatus may be a network device, a terminal device, or a third-party device (for example, a server), or the third apparatus may be disposed in the network device, the terminal device, or the third-party device. The method includes: performing L iterations of decoding on first training data by using an LDPC check matrix, and in a process of performing one iteration of decoding in the L iterations of decoding on the first training data, determining, based on a second weight, information about N variable nodes and information about M check nodes corresponding to the first training data, where the second weight belongs to a first weight set, the first weight set includes a weight corresponding to the L iterations of decoding, the second weight corresponds to the one iteration of decoding, the second weight includes one or more weights, L, N, and M are all positive integers, and L is a positive integer less than or equal to a maximum quantity of iterations of decoding; and after the L iterations of decoding, if an obtained decoding result causes a loss function corresponding to the decoding result to meet a performance requirement, ending training, to obtain the first weight set, or if an obtained decoding result fails to cause a loss function corresponding to the decoding result to meet a performance requirement, updating the first weight set, and performing an iterative decoding on second training data based on the updated first weight set.

In an optional implementation, the LDPC check matrix is determined based on a circulant permutation matrix, the circulant permutation matrix is obtained by cyclically shifting an identity matrix based on a shift value, and a quantity of rows of the identity matrix is a first lifting size.

In an optional implementation, the first lifting size is Zc.

In an optional implementation, in the one or more weights, connections in a same circulant permutation matrix correspond to a same weight, and connections in different circulant permutation matrices correspond to different weights. Therefore, a generalization capability can be improved.

In an optional implementation, a row i and a column j of the LDPC check matrix correspond to a first index, the first index corresponds to one or more values of the first lifting size, one of the values corresponds to one circulant permutation matrix, a weight corresponding to a first circulant permutation matrix corresponding to the first index includes a weight corresponding to a second circulant permutation matrix corresponding to the first index, and a value of the first lifting size corresponding to the first circulant permutation matrix is greater than a value of the first lifting size corresponding to the second circulant permutation matrix. In this way, a quantity of weights to be trained is reduced, and training complexity can be reduced.

According to a third aspect, a communication apparatus is provided. The communication apparatus may be the second apparatus according to either of the first aspect and the second aspect. The communication apparatus has the decoding function described in embodiments of this application. The communication apparatus is, for example, a terminal device or a network device, or a large device including the terminal device or the network device, or a functional module in the terminal device or the network device, for example, a baseband apparatus or a chip system. In an optional implementation, the communication apparatus includes a baseband apparatus and a radio frequency apparatus. In another optional implementation, the communication apparatus includes a processing unit (sometimes also referred to as a processing module) and a transceiver unit (sometimes also referred to as a transceiver module). The transceiver unit can implement a sending function and a receiving function. When the transceiver unit implements the sending function, the transceiver unit may be referred to as a sending unit (sometimes also referred to as a sending module). When the transceiver unit implements the receiving function, the transceiver unit may be referred to as a receiving unit (sometimes also referred to as a receiving module). The sending unit and the receiving unit may be a same functional module, the functional module is referred to as a transceiver unit, and the functional module can implement the sending function and the receiving function. Alternatively, the sending unit and the receiving unit may be different functional modules, and the transceiver unit is a general term for these functional modules.

In an optional implementation, the transceiver unit (or the receiving unit) is configured to receive a first sequence; the processing unit is configured to determine one set of weights from at least one set of weights based on a parameter of the first sequence, where the at least one set of weights is determined through training, the one set of weights includes a weight corresponding to K iterations of decoding performed on the first sequence, there are at least two different weights in the one set of weights, a quantity of weights corresponding to one iteration of decoding in the K iterations of decoding is greater than or equal to 1, and K is a positive integer less than or equal to a maximum quantity of iterations of decoding; and in a process of performing the one iteration of decoding in the K iterations of decoding on the first sequence, the processing unit is further configured to determine, based on the weight corresponding to the one iteration of decoding, information about N variable nodes and information about M check nodes corresponding to the first sequence, where both M and N are positive integers.

In an optional implementation, the communication apparatus further includes a storage unit (sometimes also referred to as a storage module). The processing unit is configured to: be coupled to the storage unit, and execute a program or instructions in the storage unit, to cause the communication apparatus to perform a function of the second apparatus according to either of the first aspect and the second aspect.

According to a fourth aspect, a communication apparatus is provided. The communication apparatus may be the third apparatus according to either of the first aspect and the second aspect. The communication apparatus has a parameter training function. The communication apparatus is, for example, a terminal device or a network device, or a large device including the terminal device or the network device, or a functional module in the terminal device or the network device, for example, a baseband apparatus or a chip system. In an optional implementation, the communication apparatus includes a baseband apparatus and a radio frequency apparatus. In another optional implementation, the communication apparatus includes a processing unit (sometimes also referred to as a processing module) and a transceiver unit (sometimes also referred to as a transceiver module). For an implementation of the transceiver unit, refer to descriptions in the third aspect.

In an optional implementation, the processing unit is configured to: perform L iterations of decoding on first training data by using an LDPC check matrix, and in a process of performing one iteration of decoding in the L iterations of decoding on the first training data, determine, based on a second weight, information about N variable nodes and information about M check nodes corresponding to the first training data, where the second weight belongs to a first weight set, the first weight set includes a weight corresponding to the L iterations of decoding, the second weight corresponds to the one iteration of decoding, the second weight includes one or more weights, L, N, and M are all positive integers, and L is a positive integer less than or equal to a maximum quantity of iterations of decoding; and after the L iterations of decoding, if an obtained decoding result causes a loss function corresponding to the decoding result to meet a performance requirement, the processing unit is further configured to: end training, to obtain the first weight set, or if an obtained decoding result fails to cause a loss function corresponding to the decoding result to meet a performance requirement, update the first weight set, and perform an iterative decoding on second training data based on the updated first weight set.

In an optional implementation, the communication apparatus further includes a storage unit (sometimes also referred to as a storage module). The processing unit is configured to: be coupled to the storage unit, and execute a program or instructions in the storage unit, to cause the communication apparatus to perform a function of the third apparatus according to either of the first aspect and the second aspect.

According to a fifth aspect, a communication apparatus is provided. The communication apparatus may be a terminal device or a network device, or may be a chip or a chip system used in the terminal device or the network device. The communication apparatus includes a communication interface and a processor, and optionally, further includes a memory. The memory is configured to store a computer program. The processor is coupled to the memory and the communication interface. When the processor reads the computer program or instructions, the communication apparatus is caused to perform the method performed by the second apparatus according to the foregoing aspects.

According to a sixth aspect, a communication apparatus is provided. The communication apparatus may be a terminal device or a network device, or may be a chip or a chip system used in the terminal device or the network device. The communication apparatus includes a communication interface and a processor, and optionally, further includes a memory. The memory is configured to store a computer program. The processor is coupled to the memory and the communication interface. When the processor reads the computer program or instructions, the communication apparatus is caused to perform the method performed by the third apparatus according to the foregoing aspects.

According to a seventh aspect, a communication apparatus is provided. The communication apparatus may be a terminal device or a network device, or may be a chip or a chip system used in the terminal device or the network device. The communication apparatus may include a control unit, a storage unit, and an LDPC decoding unit. The control unit is separately connected to the storage unit and the LDPC decoding unit. Optionally, the storage unit is connected to the LDPC decoding unit. The control unit may be implemented by using a hardware circuit or a software module. The storage unit may be implemented by using a hardware circuit or a software module. The LDPC decoding unit may be implemented by using a hardware circuit or a software module. Optionally, the control unit and the storage unit may be integrated into a chip system. The control unit, the storage unit, and the LDPC decoding unit are coupled, and may perform the method performed by the second apparatus according to the foregoing aspects.

According to an eighth aspect, a communication system is provided, including a second apparatus and a third apparatus, where the second apparatus is configured to perform the method performed by the second apparatus according to the foregoing aspects, and/or the third apparatus is configured to perform the method performed by the third apparatus according to the foregoing aspects. For example, the second apparatus may be implemented by using the communication apparatus according to the third aspect, the fifth aspect, or the seventh aspect, and the third apparatus may be implemented by using the communication apparatus according to the fourth aspect or the sixth aspect.

According to a ninth aspect, a computer-readable storage medium is provided. The computer-readable storage medium is configured to store a computer program or instructions, and when executed, the computer program or instructions cause the method performed by the second apparatus or the third apparatus according to the foregoing aspects to be implemented.

According to a tenth aspect, a computer program product including instructions is provided. When the computer program product is run on a computer, the method according to the foregoing aspects is implemented.

According to an eleventh aspect, a chip system is provided. The chip system includes a processor and an interface. The processor is configured to: invoke instructions from the interface and run the instructions, to cause the chip system to implement the method according to the foregoing aspects.

BRIEF DESCRIPTION OF DRAWINGS

FIG. 1 is a diagram of a network architecture to which an embodiment of this application is applicable;
FIG. 2 is a flowchart of a decoding method according to an embodiment of this application;
FIG. 3 is a diagram of a decoding process according to an embodiment of this application;
FIG. 4 is a diagram of a structure of second apparatus according to an embodiment of this application;
FIG. 5 is a flowchart of a parameter training method according to an embodiment of this application;
FIG. 6 is a diagram of an apparatus according to an embodiment of this application; and
FIG. 7 is a diagram of another apparatus according to an embodiment of this application.

DESCRIPTION OF EMBODIMENTS

To make objectives, technical solution, and advantages of embodiments of this application clearer, the following further describes embodiments of this application in detail with reference to the accompanying drawings.

In embodiments of this application, unless otherwise specified, a quantity of nouns represents "a singular noun or a plural noun", that is, "one or more". "At least one" means one or more, and "a plurality of" means two or more. "And/or" describes an association relationship between associated objects and indicates that three relationships may exist. For example, A and/or B may indicate the following three cases: Only A exists, both A and B exist, and only B exists, where A and B may be singular or plural. The character "/" generally indicates an "or" relationship between the associated objects. For example, A/B indicates A or B. "At least one of the following items (pieces)" or a similar expression thereof means any combination of these items, including a singular item (piece) or any combination of plural items (pieces). For example, at least one of a, b, or c indicates a, b, c, a and b, a and c, b and c, or a, b, and c, where a, b, and c may be singular or plural.

Ordinal numbers such as "first" and "second" in embodiments of this application are intended to distinguish between a plurality of objects, and are not intended to limit sizes, content, a sequence, a time sequence, priorities, importance, or the like of the plurality of objects. For example, a first weight and a second weight may be a same weight, or may be different weights. In addition, these names do not indicate that the two weights include different quantities of weights, values, application scenarios, priorities, importance degrees, or the like. In addition, step numbers in embodiments described in this application are merely intended to distinguish between different steps, but are not intended to limit a sequence of the steps. For example, S201 may be performed before S202, may be performed after S202, or may be performed simultaneously with S202.

The following describes some terms or concepts in embodiments of this application, to facilitate understanding of a person skilled in the art.

In embodiments of this application, a terminal device is a device having a wireless transceiver function, and may be a fixed device, a mobile device, a handheld device (for example, a mobile phone), a wearable device, a vehicle-mounted device, or a wireless apparatus (for example, a communication module, a modem, or a chip system) built in the foregoing device. The terminal device is configured to connect people, things, machines, and the like, and may be widely used in various scenarios. For example, the terminal device includes but is not limited to terminal devices in the following scenarios: a sensing scenario, cellular communication, device-to-device (device-to-device, D2D), vehicle-to-everything (vehicle-to-everything, V2X), machine-to-machine/machine-type communication (machine-to-machine/machine-type communication, M2M/MTC), an internet of things (internet of things, IoT), virtual reality (virtual reality, VR), augmented reality (augmented reality, AR), industrial control (industrial control), self-driving (self-driving), telemedicine (remote medical), a smart grid (smart grid), smart furniture, smart office, smart wearables, smart transportation, a smart city (smart city), an uncrewed aerial vehicle, and a robot. The terminal device may be sometimes referred to as user equipment (user equipment, UE), a terminal, an access station, a UE station, a remote station, a wireless communication device, a user apparatus, or the like.

In embodiments of this application, a communication apparatus configured to implement a function of the terminal device may be a terminal device, or may be an apparatus, for example, a chip system that supports the terminal device in implementing the function. The apparatus may be mounted in the terminal device. In the technical solutions provided in embodiments of this application, an example in which the apparatus configured to implement the function of the terminal device is a terminal device is used to describe the technical solutions provided in embodiments of this application. In addition, for ease of description, an example in which the terminal device is UE is used for description in embodiments of this application.

A network device in embodiments of this application includes, for example, an access network device and/or a core network device. The access network device is a device having a wireless transceiver function, and is configured to communicate with the terminal device. The access network device includes but is not limited to a base station (a base transceiver station (base transceiver station, BTS), a NodeB (NodeB), an evolved NodeB (evolved NodeB, eNodeB)/eNB, or a next generation NodeB (the next generation NodeB, gNodeB)/gNB), a transmission reception point (transmission reception point, TRP), a base station evolved after a 3$^{rd}$ generation partnership project (3$^{rd}$ generation partnership project, 3GPP), an access node in a wireless fidelity (wireless fidelity, Wi-Fi) system, a wireless relay node, a wireless backhaul node, and the like. The base station may be a macro base station, a micro base station, a picocell base station, a small cell, a relay station, or the like. A plurality of base stations support networks using a same access technology, or support networks using different access technologies. The base station may include one or more co-site or non-co-site transmission reception points. Alternatively, the access network device may be a radio controller, a central unit (central unit, CU), and/or a distributed unit (distributed unit, DU) in a cloud radio access network (cloud radio access network, CRAN) scenario. Alternatively, the access network device may be a server or the like. For example, a network device in the V2X technology may be a road side unit (road side unit, RSU). The following provides descriptions by using an example in which the access network device is a base station. The base station may communicate with the terminal device, or may communicate with the terminal device via a relay station. The terminal device may communicate with the plurality of base stations in different access technologies. The core network device is configured to implement functions such as mobility management, data processing, session management, and policy and charging. Names of devices that implement core network functions in systems of different access technologies may be different. This is not limited in embodiments of this application. A 5$^{th}$ generation (the 5$^{th}$ generation, 5G) mobile communication technology system is used as an example. The core network device includes an access and mobility management function (access and mobility management function, AMF), a session management function (session management function, SMF), a policy control function (policy control function, PCF), a user plane function (user plane function, UPF), or the like.

In embodiments of this application, a communication apparatus configured to implement a function of the network device may be a network device, or may be an apparatus, for example, a chip system, that supports the network device in implementing the function. The apparatus may be mounted in the network device. In the technical solutions provided in embodiments of this application, an example in which the apparatus configured to implement the function of the network device is a network device is used to describe the technical solutions provided in embodiments of this application.

There are a plurality of encoding/decoding schemes for LDPC. A process of BP decoding in the plurality of encoding/decoding schemes is essentially a process of iteratively transferring belief information between a variable node and a check node in an LDPC check matrix. BP decoding may undergo multiple iterations. In a single iteration, information about each variable node and information about each check node in the LDPC check matrix are calculated. Reference may be made to the following formulas for calculating such information.

$$r_{nk} = 2\tanh^{-1}\left(\prod_{k'}\tanh\left(\tfrac{1}{2}q_{nk'}\right)\right), \{k' \in \mathcal{K}(n), k' \neq k\} \qquad \text{(Formula 1)}$$

Formula 1 is used to calculate information about the check node.

$$q_{nk} = \log\frac{q_{nk}(0)}{q_{nk}(1)} = \log\frac{p_k(0)}{p_k(1)} + \log\prod_{n'}\frac{r_{n'k}(0)}{r_{n'k}(1)} = \log\frac{p_k(0)}{p_k(1)} + \sum_{n'}\log\frac{r_{n'k}(0)}{r_{n'k}(1)} = l_k + \sum_{n'}r_{n'k} \ \{n' \in$$

$$\mathcal{N}(k), n' \neq n\} \quad \text{(Formula 2)}$$

Formula 2 is used to calculate information about the variable node. For example, in a single iteration, information about each variable node may be calculated by using Formula 2, and information about each check node may be calculated by using Formula 1.

In the foregoing formulas, $r_{nk}$ represents a log-likelihood rate (likelihood rate, LLR) of a probability that a check node n meets checking when a $k^{th}$ information bit in the check node n is 0 to a probability that the check node n meets the check when the $k^{th}$ information bit in the check node n is 1. $q_{nk}$ represents a log-likelihood rate of a probability that the $k^{th}$ information bit in the check node n is equal to 0 to a probability that the $k^{th}$ information bit in the check node n is equal to 1. A set of all information bits included in the check node n is denoted as $\mathcal{K}(n) = \{k: H_{n,k} = 1\}$, and a set including all check nodes including the $k^{th}$ information bit is denoted as $\mathcal{N}(k) = \{n: H_{n,k} = 1\}$. In the foregoing formulas, $q_{nk}(0)$ represents a probability that another check equation (check node) other than an $n^{th}$ check equation (check node n) meets a condition when $x_k = 0$, and may be considered as information transferred by a variable node k to the check node n; $q_{nk}(1)$ represents a probability that another check equation other than the $n^{th}$ check equation meets a condition when $x_k = 1$, and may be considered as information transferred by the variable node k to the check node n; $p_k(0)$ represents a posterior probability that an initially sending bit, that is, $x_k$, is equal to 0 and $p_k(1)$ represents a posterior probability that the initially sending bit $x_k = 1$. $r_{n'k}(0)$ represents a probability that the $n^{th}$ check equation meets the check when $x_k = 0$, and may be considered as information transferred by the check node n to the variable node k; $r_{n'k}(1)$ represents a probability that the $n^{th}$ check equation meets the check when $x_k = 1$, and may be considered as information transferred by the check node n to the variable node k;

$l_k = \log\dfrac{p_k(0)}{p_k(1)}$; $n'$ represents a check node n' in the set $\mathcal{N}(k)$, $k'$ represents a $k'^{th}$ information bit in the set $\mathcal{K}(n)$, $\tanh^{-1}$ represents an inverse function of tanh(x), and $\prod x$ represents a concatenation multiplication operation.

It can be learned that, in the calculation process, there are a large quantity of multiplication operations and tanh(x) operations, resulting in high complexity and imposing a high requirement on performance of a decoding apparatus, and this may also cause low decoding efficiency.

Therefore, a minimum sum (min-sum, MS) decoding mode is further provided currently. Formulas used in this decoding mode are as follows:

$$r_{nk} \approx 2s_{nk}\cdot\tanh^{-1}\left(tanh\left(\min_{k'}\left|\tfrac{1}{2}q_{nk'}\right|\right)\right) = s_{nk}\cdot\min_{k'}|q_{nk'}| \qquad \text{(Formula 3)}$$

$$q_{nk} = \log\frac{q_{nk}(0)}{q_{nk}(1)} = \log\frac{p_k(0)}{p_k(1)} + \log\prod_{n'}\frac{r_{n'k}(0)}{r_{n'k}(1)} = l_k + \sum_{n'}r_{n'k} \ \{n' \in \mathcal{N}(k), n' \neq n\}$$

$$\text{(Formula 4)}$$

Formula 3 is used to calculate the information about the check node, and Formula 4 is used to calculate the information about the variable node. In the foregoing formulas, $s_{nk}$ represents a product of symbols of all $q_{nk}$ of all variable nodes (except the variable node k) connected to the check node n; $q_{nk'}$ represents a log-likelihood rate of a probability of a variable node $q_{nk'}(0)$ to a probability of a variable node $q_{nk'}(1)$; $\min_{k'}|q_{nk'}|$ represents a minimum absolute value of all $q_{nk}$ of all the variable nodes (except the variable node k) connected to the check node n; and $|x|$ represents calculating an absolute value of x.

In an MS decoding process, although there is no large quantity of multiplication and tanh(x) operation processes when the information about the check node is calculated, an obtained calculation result of $r_{nk}$ is relatively large. Currently, two compensation manners may be used. For one compensation manner, refer to Formula 5:

$$r_{nk} = \alpha * s_{nk} \cdot \min_{k'}|q_{nk'}| \qquad \text{(Formula 5)}$$

In Formula 5, $\alpha$ represents a compensation coefficient, and a value of $\alpha$ is greater than 0 and less than 1.

For another compensation manner, refer to Formula 6:

$$r_{nk} = s_{nk} \cdot \max\{\min_{k'}|q_{nk'}| - \beta, 0\} \qquad \text{(Formula 6)}$$

In Formula 6, $\beta$ represents a compensation coefficient, and a value of $\beta$ is greater than 0 and less than 1.

It can be learned that, in MS decoding, $r_{nk}$ may be compensated by using the compensation coefficient. The compensation coefficients $\alpha$ and $\beta$ are generally obtained through simulation. In the decoding process, values of $\alpha$ and $\beta$ are fixed, and this limits the decoding process and reduces decoding performance.

In view of this, in embodiments of this application, information about a variable node and information about a check node may be determined based on weights, and this is equivalent to adding the weight as compensation. Therefore, calculation complexity can be reduced, and performance requirements on the decoding apparatus can be lowered, making the technical solutions in embodiments of this application more widely applicable. In addition, in embodiments of this application, the at least one set of weights may be obtained through training. If a quantity of the at least one set is greater than 1, one set of weights in the at least one set of weights may be used in one round of decoding process (including multiple iterations of decoding), and different sets of weights may be used in different rounds of decoding processes. In different iterative decoding processes in one round of decoding process, different weights in one set of weights may also be used. In addition, if a quantity of weights corresponding to one iteration of decoding is greater than 1, different weights may also be used for different calculations even in a process of one iteration of decoding. It can be learned that in embodiments of this application, corresponding weights may be applied to different calculation processes during decoding, making the weights better match the corresponding calculation processes. Therefore, decoding flexibility is improved, and decoding performance is enhanced.

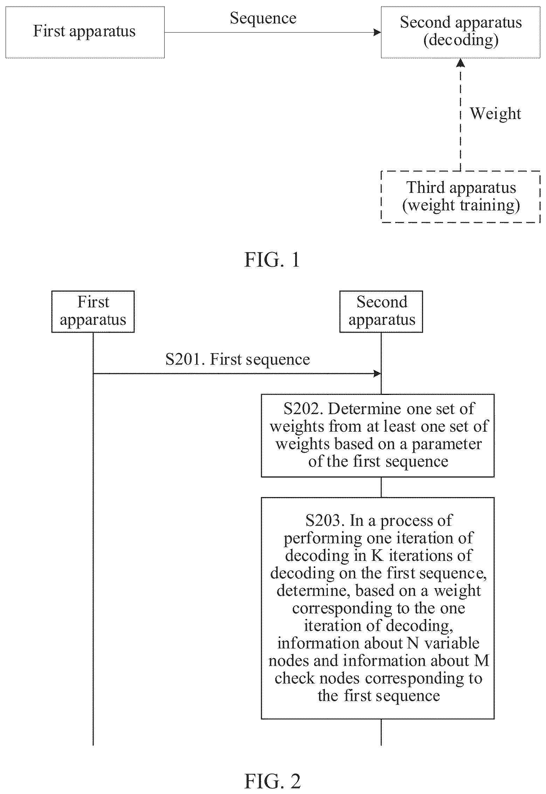

FIG. 1 shows a communication network architecture to which an embodiment of this application is applicable. FIG. 1 includes a first apparatus and a second apparatus. The first apparatus is a sequence transmit end, or may be referred to as an encoding end, and may perform an encoding process. The first apparatus may be a network device or a terminal device. The second apparatus is a sequence receive end, or may be referred to as a decoding end, and may perform the decoding method provided in embodiments of this application. The second apparatus may be a network device or a terminal device. A weight used in embodiments of this application may be obtained through training. An apparatus used for weight training may be the second apparatus, or may be the first apparatus or a third-party apparatus (for example, a third apparatus shown in FIG. 1). After training is completed, the first apparatus or the third-party apparatus may send the obtained weight to the second apparatus.

To better describe embodiments of this application, the following describes, with reference to the accompanying drawings, a method provided in embodiments of this application. In embodiments of this application, the "weight" may also be referred to as a "compensation coefficient" or a "coefficient", or may have another name. Unless otherwise specified below, in accompanying drawings corresponding to embodiments of this application, steps represented by dashed lines are all optional steps. Methods provided in embodiments of this application may be applied to the network architecture shown in FIG. 1. For example, a first apparatus in each embodiment of this application may be the first apparatus in FIG. 1, a second apparatus in each embodiment of this application may be the second apparatus in FIG. 1, and a third apparatus in each embodiment of this application may be the third apparatus in FIG. 1.

An embodiment of this application provides a decoding method. FIG. 2 is a flowchart of the method.

S201. A first apparatus sends a first sequence. Correspondingly, a second apparatus receives the first sequence.

For example, the first apparatus obtains the first sequence by encoding original information by using an LDPC code, and sends the first sequence. In this case, the first sequence received by the second apparatus is a sequence obtained through LDPC encoding.

S202. The second apparatus determines one set of weights from at least one set of weights based on a parameter of the first sequence. For example, the one set of weights determined by the second apparatus is referred to as weight set A.

First, a decoding process is described. The second apparatus may decode the received sequence by using an LDPC check matrix. Generally, the LDPC code may be represented by a parity check matrix H, and H may also be referred to as the LDPC check matrix. The LDPC check matrix may be obtained based on a base graph (base graph) and a shift (shift) value. The base graph may generally include m*n matrix entries (entry), and may be represented in a form of a matrix with m rows and n columns. A value of a matrix entry is 0 or 1. An entry with a value of 0 is sometimes also referred to as a zero entry, and it indicates that the entry can be replaced with a Zc*Zc all-zero matrix (zero matrix). An entry with a value of 1 is sometimes also referred to as a non-zero entry, and it indicates that the entry can be replaced with a Zc*Zc circulant permutation matrix (circulant permutation matrix). It may be understood as that each entry in the matrix with m rows and n columns represents an all-zero matrix or a circulant permutation matrix. Table 1 is an example of a base graph. In this specification, row indexes and column indexes of the base graph and the matrix are all numbered from 0. This is merely for ease of description. For example, the column number 0 represents the 1st column of the base graph and the matrix, and the column number 1 represents the 2nd column of the base graph or the matrix; and the row number 0 represents the 1st row of the base graph or the matrix, and the row number 1 represents the 2nd row of the base graph or the matrix. The rest are deduced by analogy.

Table 1

| H | | $V_{i,j}$ | | | | | | | | H | | $V_{i,j}$ | | | | | | | |
|---|---|---|---|---|---|---|---|---|---|---|---|---|---|---|---|---|---|---|---|
| | | Set index (set index)$i_{LS}$ | | | | | | | | | | Set index (set index)$i_{LS}$ | | | | | | | |
| Row index i | Column index j | 0 | 1 | 2 | 3 | 4 | 5 | 6 | 7 | Row index i | Column index j | 0 | 1 | 2 | 3 | 4 | 5 | 6 | 7 |
| 0 | 0 | 9 | 174 | 0 | 72 | 3 | 156 | 143 | 145 | 16 | 26 | 0 | 0 | 0 | 0 | 0 | 0 | 0 | 0 |
| | 1 | 117 | 97 | 0 | 110 | 26 | 143 | 19 | 131 | 17 | 1 | 254 | 158 | 0 | 48 | 120 | 134 | 57 | 196 |
| | 2 | 204 | 166 | 0 | 23 | 53 | 14 | 176 | 71 | | 5 | 124 | 23 | 24 | 132 | 43 | 23 | 201 | 173 |
| | 3 | 26 | 66 | 0 | 181 | 35 | 3 | 165 | 21 | | 11 | 114 | 9 | 109 | 206 | 65 | 62 | 142 | 195 |
| | 6 | 189 | 71 | 0 | 95 | 115 | 40 | 196 | 23 | | 12 | 64 | 6 | 18 | 0 | 42 | 163 | 35 | 218 |
| | 9 | 205 | 172 | 0 | 8 | 127 | 123 | 13 | 112 | | 27 | 0 | 0 | 0 | 0 | 0 | 0 | 0 | 0 |
| | 10 | 0 | 0 | 0 | 1 | 0 | 0 | 0 | 1 | 18 | 0 | 220 | 183 | 0 | 68 | 17 | 173 | 129 | 128 |
| | 11 | 0 | 0 | 0 | 0 | 0 | 0 | 0 | 0 | | 6 | 194 | 6 | 18 | 16 | 106 | 31 | 203 | 211 |

EP 4 718 731 A1

In Table 1, values like 9 and 174 represent shift values. If a value of an entry in row i and column j in the base graph is 1, and a shift value of the entry is $Q_{i,j}$, it indicates that the entry, in row i and column j, with the value of 1 may be replaced with a Z*Z circulant permutation matrix corresponding to $Q_{i,j}$, where $Q_{i,j}$ is an integer greater than or equal to 0. The circulant permutation matrix may be obtained by cyclically shifting a Z*Z identity matrix to the right for $Q_{i,j}$ times. It may be learned that, in the base graph, each entry with a value of 0 is replaced with a Z*Z all-zero matrix, and each entry with a value of 1 is replaced with a Z*Z circulant permutation matrix corresponding to a shift value of the entry, so that the LDPC check matrix can be obtained. Z is a positive integer, may also be referred to as a lifting size (lifting size), represents a quantity of rows or a quantity of columns of an identity matrix (because the circulant permutation matrix is obtained by cyclically shifting the identity matrix, and a quantity of rows and a quantity of columns of the circulant permutation matrix are the same as those of the identity matrix, Z also represents the quantity of rows or the quantity of columns of the circulant permutation matrix), and may be determined based on a code block size supported by a system and a size of information data. For example, in this embodiment of this application, a lifting size used by the second apparatus is a first lifting size Zc.

It can be learned that a size of the LDPC check matrix H is (m*Z)*(n*Z). For example, if the lifting size Z=4, each zero entry in the base graph is replaced with an all-zero matrix with a size of 4*4, and each non-zero entry in the base graph is replaced with a circulant permutation matrix with a size of 4*4. The circulant permutation matrix is obtained by cyclically shifting a 4*4 identity matrix to the right for $Q_{i,j}$ times.

A same set index may correspond to one or more values of Z, or a same set index may correspond to one or more Zs. In other words, quantities of rows and quantities of columns of identity matrices applied to a same set index may be different. For example, Table 2 shows an example in which a same set index may correspond to different values of Z. In Table 2, one set index may correspond to one value set of Z.

Table 2

| set index | Z |
|-----------|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28, 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |

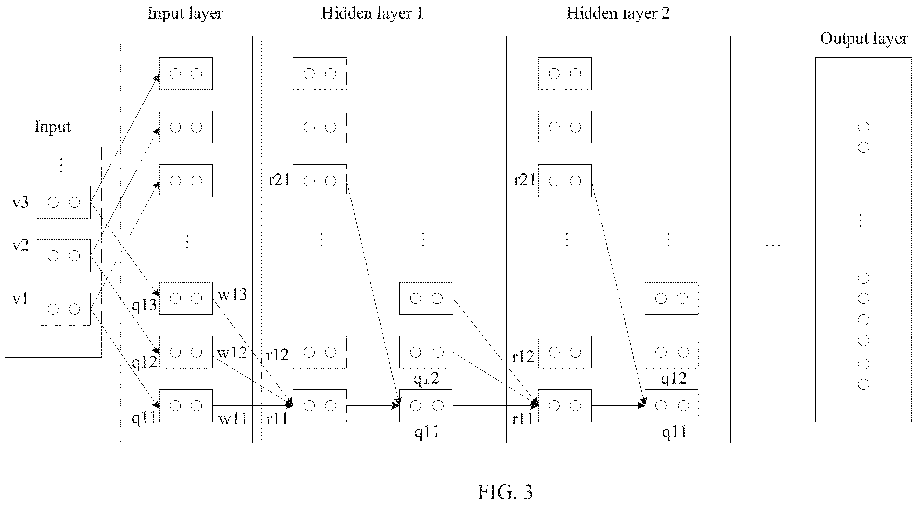

In the LDPC check matrix, one row represents one check node (or referred to as a check equation), and one column represents one variable node. A decoding process is a process of continuously iteratively calculating information about each node in the LDPC check matrix. For example, the LDPC check matrix is considered as a neural network. Refer to FIG. 3, the neural network includes an input layer, hidden layers, and an output layer. The following describes a decoding process of the second apparatus with reference to FIG. 3, where a dot in FIG. 3 represents $r_{nk}$ or $q_{nk}$.

After receiving the first sequence, the second apparatus may group variable nodes in the LDPC check matrix based on the first lifting size, and a quantity of variable nodes included in each group is a value of the first lifting size. For example, the first lifting size is Zc. In FIG. 3, an example in which Zc=2 is used. For example, v1, v2, v3, and the like that are input in FIG. 3 represent different groups of variable nodes. In this case, a value is not assigned to each node in the check matrix. After grouping, the second apparatus may initialize information about all variable nodes included in the LDPC check matrix (where information before the initialization is q11, q12, q13, and the like in the input layer in FIG. 3), to obtain updated information of all the variable nodes, for example, which is referred to as information A about the variable nodes, for example, w11, w12, and w13 in the input layer (input layer) in FIG. 3. In an initialization process, a process of obtaining the circulant permutation matrix based on the identity matrix is completed. The second apparatus may calculate information about all check nodes in the LDPC check matrix based on the information A about the variable nodes. For example, the information A about the variable nodes is substituted as $q_{nk}$ into Formula 3, to calculate the information about the check nodes, for example, which is referred to as information A about the check nodes, for example, r11, r12, and the like in a hidden layer (hidden layer) 1 in FIG. 3. In addition, the second apparatus may further calculate information about all the variable nodes in the LDPC check matrix based on the information A about the check nodes. For example, the information A about the check nodes is substituted as $r_{nk}$ into Formula 4, to obtain the re-updated information about the variable nodes, for example, which is referred to as information B about the variable nodes, for example, q11, q12, and the like in the hidden layer 1 in FIG. 3. So far, the second apparatus completes one iterative decoding process. Each variable node in the LDPC check matrix may be connected to some or all check nodes in the LDPC check matrix, and each check node in the LDPC check matrix may be connected to some or all variable nodes in the LDPC check matrix. Information about a variable node includes information about connections between the variable node and all check nodes that have connection relationships with the variable node. Therefore, calculating information about a variable node is calculating information about all connections corresponding to the variable node, in other words, calculating information about a connection between the variable node and each check node connected to the variable node. For example, if a variable node 1 is connected to both a check node 1 and a check node 2, information about the variable node 1 includes information about a connection between the variable node 1 and the check node 1, and information about a connection between the variable node 1 and the check node 2. The same applies to information about a check node. Information about a check node includes information about connections between the check node and all variable nodes that have connections to the check node. Therefore, calculating information about a check node is calculating information about all connections corresponding to the check node, in other words, calculating information about a connection between the check node and each variable node that has a connection relationship with the check node. For example, if a check node 1 is connected to both a variable node 1 and a variable node 2, information about the check node 1 includes information about a connection between the check node 1 and the variable node 1, and information about a connection between the check node 1 and the variable node 2. Formula 4 may be used to calculate information about each connection corresponding to the variable node, and Formula 3 may be used to calculate information about each connection corresponding to the check node.

That the second apparatus obtains the information B about the variable nodes and the information A about the check nodes through calculation is equivalent to completing one iteration of decoding. Optionally, after the one iteration of decoding is completed, the second apparatus may obtain a result of the current iteration of decoding based on the information about the variable nodes and the information about the check nodes that are obtained in the current iteration of decoding, and may perform decision on the result of the current iteration of decoding. If the decision is 0, the result of the current iteration of decoding (for example, a node in the output layer (output layer) in FIG. 3) may be output, the decoding is completed, and the result of the iterative decoding is a final decoding result; or if the decision is not 0, the second apparatus may perform a next iteration of decoding until the decision of a result of a specific iteration of decoding is 0 or until a maximum quantity of iterations of decoding is reached. For example, the second apparatus may obtain the result of the current iteration of decoding based on the information B about the variable node and the information A about the check node, and the second apparatus may perform decision on the result of the current iteration of decoding. For example, if the decision is not 0, the second apparatus may continue to perform a next iteration of decoding.

In a process of the next iteration of decoding, the second apparatus may calculate information about all the check nodes in the LDPC check matrix based on the information B about the variable node. For example, the information B about the variable nodes is substituted as $q_{nk}$ into Formula 3, to calculate the updated information about the check nodes, for example, which is referred to as information B about the check nodes, for example, r11, r12, and the like in a hidden layer 2 in FIG. 3. In addition, the second apparatus may further calculate information about all the variable nodes in the LDPC check matrix based on the information B about the check nodes. For example, the information B about the check nodes is substituted as $r_{nk}$ into Formula 4, to obtain updated information about the variable nodes, for example, which is referred to as information C about the variable nodes, for example, q11, q12, and the like in the hidden layer 2 in FIG. 3. The second apparatus obtains the information C about the variable nodes and the information B about the check nodes through calculation, and therefore, another iteration of decoding is completed, and the second apparatus may perform decision in the manner described above, and the rest may be deduced by analogy. For example, the second apparatus obtains a final decoding result through one or more iterations of decoding, as shown by the rightmost output layer in FIG. 3.

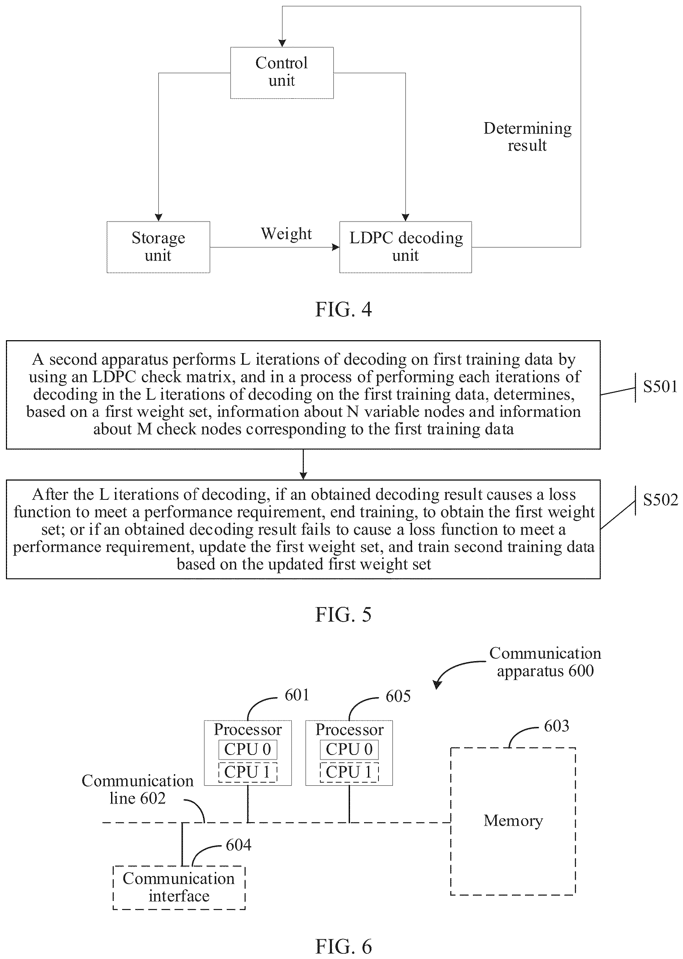

In the foregoing decoding process, when calculating information about the check node (or when calculating information about each connection corresponding to the check node), the second apparatus may use a corresponding weight to compensate $r_{nk}$ obtained through calculation. For example, the weight includes $\alpha$ and/or $\beta$, or may include another type of weight. In this embodiment of this application, after receiving the first sequence, the second apparatus may select, from the at least one set of weights, one set of weights corresponding to K iterations of decoding used to decode the first sequence. For example, FIG. 4 is a diagram of a structure of a second apparatus. The second apparatus includes a control unit, a storage unit, and an LDPC decoding unit. The control unit is connected to the storage unit, and the control unit is connected to the LDPC decoding unit. The at least one set of weights is stored in the storage unit included in the second apparatus. After receiving the first sequence, the second apparatus may select one set of weights (which is selected by, for example, the control unit included in the second apparatus) from the storage unit. The control unit may input the set of weights and the first sequence into the LDPC decoding unit, and the LDPC decoding unit performs decoding. In this manner, there may be no connection or a connection between the LDPC decoding unit and the storage unit. Alternatively, the control unit may indicate the storage unit to input the set of weights into the LDPC decoding unit, the control unit may input the first sequence into the LDPC decoding unit, and the LDPC decoding unit performs decoding. In this manner, there may be a connection between the LDPC decoding unit and the storage unit. This is used as an example in FIG. 4. After each iteration of decoding, the LDPC decoding unit may input, into the control unit, information about a check node and information about a variable node that are obtained in the current iteration of decoding; and the control unit obtains a decoding result of the current iteration of decoding based on the information, and performs decision based on the decoding result, to determine whether the decoding succeeds. Alternatively, after each iteration of decoding, the LDPC decoding unit may obtain a decoding result of the current iteration of decoding based on information about a check node and information about a variable node that are obtained in the current iteration of decoding, and then input the decoding result into the control unit, and the control unit performs determining based on the decoding result, to determine whether the decoding succeeds. Alternatively, after each iteration of decoding, the LDPC decoding unit may obtain a decoding result of the current iteration of decoding based on information about a check node and information about a variable node that are obtained in the current iteration of decoding, perform decision based on the decoding result, and then input a decision result (for example, the decision result is 0 or is not 0) into the control unit; and the control unit determines, based on the decision result, whether the decoding succeeds. This is used as an example in FIG. 4. If the current decoding fails, the control unit may determine whether a quantity of decoding attempts reaches K, and if the quantity of decoding attempts reaches K, the decoding is completed, and the control unit may output the decoding result; or if the quantity of decoding attempts is less than K, the control unit may indicate the LDPC decoding unit to perform a next iteration of decoding.

The control unit may be implemented using a software module, or may be implemented using a hardware circuit. For example, the control unit may also be referred to as a controller, and includes a general-purpose central processing unit (central processing unit, CPU), a microprocessor, an application specific integrated circuit (application specific integrated circuit, ASIC), or one or more integrated circuits configured to control program execution in embodiments of this application. The storage unit may be implemented through a software module, or may be implemented through a hardware circuit. For example, the storage unit includes a read-only memory (read-only memory, ROM) and/or a random access memory (random access memory, RAM). The LDPC decoding unit may be implemented through a software module, or may be implemented through a hardware circuit. For example, the LDPC decoding unit may also be referred to as an LDPC decoder (decoder) or the like. The control unit, the storage unit, and the LDPC decoding unit may be three independent functional units, and are implemented through different hardware circuits or software modules. Alternatively, the control unit and the storage unit may be integrated in a chip, and the chip and the LDPC decoding unit may be two independent functional units.

K is a positive integer less than or equal to a maximum quantity of iterations of decoding. The maximum quantity of iterations of decoding may be predefined in a protocol, or may be configured by the first apparatus or the second apparatus. For example, K is the maximum quantity of iterations of decoding. It can be learned from the foregoing descriptions that a quantity of decoding attempts performed on the first sequence may not reach the maximum quantity of iterations of decoding. For example, after a specific iteration of decoding is performed on the first sequence, if a decision result is not 0, the decoding ends. If the quantity of decoding attempts performed on the first sequence does not reach the maximum quantity of iterations of decoding, some weights (to be specific, weights corresponding to one or more times of unperformed iterative decoding) in the set of weights are not used. For example, the second apparatus may select, from the at least one set of weights based on the parameter of the first sequence, one set of weights applicable to the first sequence. For example, the parameter of the first sequence includes one or more of the following: information about a base graph corresponding to the first sequence, a bit rate of the first sequence, a modulation parameter of the first sequence, or channel state information of the first sequence. Currently, there are two types of optional base graphs (Table 1 shows some content in one type of base graph), and the information about the base graph corresponding to the first sequence may indicate which base graph is used. The channel state information of the first sequence includes, for example, information such as a maximum delay spread and/or a power delay profile (power delay profile, PDP) of the first sequence.

The at least one set of weights may be obtained through neural network training. For example, during training, parameters of a sequence (or referred to as a training sample) participating in the training may be different. Therefore, the at least one set of weights may be obtained through training. Each set of weights may correspond to different parameters of the sequence, or correspond to different values of a sequence parameter. In the at least one set of weights, each set of weights may include one or more weights, and each set of weights may include a weight corresponding to the K iterations of decoding performed on the first sequence. In each set of weights, a quantity of weights corresponding to the one iteration of decoding in the K iterations of decoding is greater than or equal to 1. Optionally, one set of weights in the at least one set of weights may include $\alpha$ and/or $\beta$, or may further include another weight. For example, one set of weights may include $\alpha$ and/or $\beta$; or one set of weights may include $\alpha$ but not $\beta$, and another set of weights may include $\beta$ but not $\alpha$. For another example, in one set of weights, a weight corresponding to one iteration of decoding may include $\alpha$ and/or $\beta$; or a weight corresponding to one iteration of decoding may include $\alpha$ but not $\beta$, and a weight corresponding to another iteration of decoding may include $\beta$ but not $\alpha$. For example, if a weight corresponding to one iteration of decoding includes $\alpha$ and $\beta$, when information about a connection corresponding to a check node is calculated, only one of $\alpha$ and $\beta$ may be applied, or both of the two weights may be applied.

The at least one set of weights may meet one or more of the following relationships: In each set of weights in the at least one set of weights, there is at least one different weight in weights corresponding to at least two times of iterative decoding; in each set of weights in the at least one set of weights, there are at least two different weights in weights corresponding to a same iteration of decoding; or if a quantity of the at least one set of weights is greater than 1, there is at least one different weight in at least two sets of weights in the at least one set of weights.

That there is at least one different weight in the weights corresponding to the at least two times of iterative decoding may include that there are different quantities of weights corresponding to the two times of iterative decoding, where for example, a quantity of weights corresponding to one of the two times of iterative decoding is P1, a quantity of weights corresponding to the other iteration of decoding is P2, and P1 is not equal to P2; and/or includes that there are two different corresponding weights in the included weights corresponding to the two times of iterative decoding. For example, in a weight corresponding to one of the two times of iterative decoding, a weight 1 participates in calculating 1, and in a weight corresponding to the other iteration of decoding, a weight 2 participates in calculating 1, and the weight 1 is different from the weight 2.

There are at least two different weights in the weights corresponding to the same iteration of decoding. For example, if the weights corresponding to the same iteration of decoding may be used in different calculation processes, at least two weights corresponding to calculation processes are different.

S203. In a process of performing the one iteration of decoding in the K iterations of decoding on the first sequence, the second apparatus determines, based on a weight corresponding to the current iteration of decoding, information about N variable nodes and information about M check nodes corresponding to the first sequence, where both M and N are positive integers. For example, the N variable nodes are all variable nodes in the LDPC check matrix, and the M check nodes are all check nodes in the LDPC check node.

The process is described in S202. For details, refer to the content of S202.

Optionally, when the second apparatus decodes the first sequence, connections in a same circulant permutation matrix in the LDPC check matrix correspond to a same weight. Because the same circulant permutation matrix corresponds to a same edge of the LDPC check matrix, weights may be the same. In other words, for connections in a same circulant permutation matrix (including, for example, a connection between a check node in the circulant permutation matrix and a variable node in the circulant permutation matrix), the second apparatus may use a same weight to calculate information about different connections in the connections, or it is understood as that a same circulant permutation matrix may correspond to a same weight. In this way, a quantity of weights can be reduced, and a training process can be simplified.

Optionally, when the second apparatus decodes the first sequence, different circulant permutation matrices in the LDPC check matrix correspond to different weights. Because different circulant permutation matrices correspond to different edges of the LDPC check matrix, the weights may be different. In other words, for connections in different circulant permutation matrices, the second apparatus may use different weights when calculating information about the connections. For example, based on the descriptions in the previous paragraph, a circulant permutation matrix 1 may correspond to a weight 1, a circulant permutation matrix 2 may correspond to a weight 2, and the weight 1 and the weight 2 may be different.

In addition, as described above, a same set index may correspond to one or more values of a lifting size, as shown in Table 2. In this embodiment of this application, a same set index may correspond to one or more values of the first lifting size, or a same set index may correspond to one or more lifting sizes. For example, the set index is referred to as an index for short. Row i and column j of the LDPC check matrix correspond to, for example, a first index. The first index may correspond to one or more values of the first lifting size. For row i and column j, one of the values of the first lifting size may correspond to one circulant permutation matrix. Optionally, for row i and column j, weights corresponding to different circulant permutation matrices corresponding to the first index may be in an inclusion relationship. For example, for row i and column j, when the first index is a specific value, different values of the first lifting size correspond to different circulant permutation matrices. For example, a first value of the first lifting size corresponds to a first circulant permutation matrix, and a second value of the first lifting size corresponds to a second circulant permutation matrix. For example, if the first value is greater than the second value, a weight corresponding to the first circulant permutation matrix may include a weight corresponding to the second circulant permutation matrix. For example, for row i and column j, when the first index is 0, a value of 256 of the first lifting size corresponds to the first circulant permutation matrix, and a value of 128 of the first lifting size corresponds to the second circulant permutation matrix. For example, the first circulant permutation matrix corresponds to K1 weights, and the second circulant permutation matrix corresponds to K2 weights. In this case, the K1 weights corresponding to the first circulant permutation matrix may include the K2 weights corresponding to the second circulant permutation matrix. In other words, for a specific row and a specific column in the LDPC check matrix, in a specific set index, a weight of a circulant permutation matrix corresponding to a smaller value of the first lifting size may be included in a weight of a circulant permutation matrix corresponding to a larger value of the first lifting size. Therefore, a quantity of weights to be trained is reduced, and training complexity can be reduced.

A weight corresponding to one iteration of decoding includes, for example, a first weight. The first weight may be used to determine information about a first connection. The first connection may be a connection between a variable node A in the N variable nodes and a check node A in the M check nodes. The variable node A is any variable node in the N variable nodes, and the check node A is any check node in the M check nodes. The first connection is, for example, a connection corresponding to the check node A, and/or a connection corresponding to the variable node A. Optionally, if the first weight is less than a first threshold, information about the check node A may not include the information about the first connection, and/or information about the variable node A may not include the information about the first connection. It may be understood as that if a weight used to calculate information about a specific connection is less than the first threshold, the connection may be less effective. Therefore, the information about the connection may not need to be calculated, thereby reducing a calculation amount and reducing decoding complexity. The first threshold is, for example, 0.05, or may be another value.

Optionally, in a process of performing the one iteration of decoding, the second apparatus may sequentially calculate information about each variable node in the N variable nodes and information about each check node in the M check nodes in a serial manner. This manner may also be referred to as a flooding (flooding) decoding mode. Because the above is a serial calculation process, information about a specific node obtained through a specific time of calculation may be used in a next time of iterative update of the node.

Optionally, the N variable nodes and the M check nodes may alternatively be grouped, or nodes included in the LDPC check matrix are grouped, and decoding is performed based on a group. This manner may also be referred to as a layered (layered) decoding mode. A grouping manner may be determined by the second apparatus or may be predefined in a protocol. For example, each group includes one or more variable nodes in the N variable nodes, and/or includes one or more check nodes in the M check nodes. For example, a quantity of variable nodes included in one group is less than N, and/or a quantity of check nodes included in one group is less than M. In the process of one iteration of decoding, calculation processes between any two groups in the at least one group may be performed in a parallel manner, and a calculation process in one group may be performed in a serial manner. Due to parallel processing between groups, decoding efficiency is improved, and an iterative convergence speed is increased.

After the one iteration of decoding in S203 is completed, the second apparatus may obtain a result of the current iteration of decoding based on the information about the N variable nodes and the information about the M check nodes that are obtained in the current iteration of decoding, and may perform decision on the result of the current iteration of decoding. If a decision result is 0, the result of the current iteration of decoding may be output, the decoding is completed, and the result of the iterative decoding is a final decoding result; or if a decision result is not 0, the second apparatus may perform a next iteration of decoding in the K iterations of decoding until a result of a specific iteration of decoding in the K iterations of decoding is decided as 0, or until a quantity of times of iterative decoding reaches K.

In conclusion, in this embodiment of this application, the information about the variable node and the information about the check node may be determined by using the weight, and this is equivalent to adding the weight as compensation. Therefore, calculation complexity can be reduced, and performance requirements on the decoding apparatus can be lowered, making the technical solutions in embodiments of this application more widely applicable. In addition, in embodiments of this application, the at least one set of weights may be obtained through training. If a quantity of the at least one set is greater than 1, one set of weights in the at least one set of weights may be used in one round of decoding process (including multiple iterations of decoding), and different sets of weights may be used in different rounds of decoding processes. In different iterative decoding processes in one round of decoding process, different weights in one set of weights may be used. In addition, if a quantity of weights corresponding to one iteration of decoding is greater than 1, different weights may also be used for different calculations even in a process of one iteration of decoding. It can be learned that in embodiments of this application, corresponding weights may be applied to different calculation processes during decoding, making the weights better match the corresponding calculation processes. Therefore, decoding flexibility is improved, and decoding performance is enhanced.

In the embodiment shown in FIG. 2, the weight obtained through training is applied. The following describes a parameter training method provided in embodiments of this application. By using the method, how to obtain the at least one set of weights in the embodiment shown in FIG. 2 through training is described. FIG. 5 is a flowchart of the method. In the following description process, an example in which a second apparatus performs training is used. As described above, training may alternatively be performed by a first apparatus or a third apparatus.

S501. The second apparatus performs L iterations of decoding on first training data by using an LDPC check matrix, and in a process of performing each iteration of decoding in the L iterations of decoding on the first training data, determines, based on a first weight set, information about N variable nodes and information about M check nodes corresponding to the first training data. For example, the LDPC check matrix may be considered as a neural network. Therefore, the embodiment shown in FIG. 5 relates to a process of training a parameter based on the neural network.

L, M, and N are all positive integers, where L is a positive integer less than or equal to a maximum quantity of iterations of decoding. For example, L may be the same as or different from K in the embodiment shown in FIG. 2. In this embodiment of this application, L may be a quantity of times of iterative decoding actually performed on the first training data. For example, if the maximum quantity of iterations of decoding is 10, and a loss function can meet a performance requirement after eight times of iterative decoding are performed on the first training data, L may be equal to 8. If a loss function can meet a performance requirement only after 10 times of iterative decoding are performed on the first training data, or a loss function cannot meet a performance requirement after 10 times of iterative decoding are performed on the first training data, L may be equal to 10.

In this embodiment of this application, in a training process, an entire set of weights may be trained. One set of weights may include one or more weights. The first weight set is one of the sets of weights, and the first weight set may include a weight corresponding to the L iterations of decoding. For example, it is understood as that the first weight set includes L subsets, where each subset is used for one iteration of decoding in the L iterations of decoding. For example, a subset corresponding to a specific iteration of decoding in the L iterations of decoding is referred to as a second weight, and the second weight may be used in the process of the current iteration of decoding. Each subset in the L subsets may include one or more weights. For example, a weight in a subset may include $\alpha$ and/or $\beta$; or a subset includes $\alpha$ but not $\beta$, and another subset includes $\beta$ but not $\alpha$; or a weight set includes $\alpha$ and/or $\beta$; or a weight set includes $\alpha$ but not $\beta$, and another weight set includes $\alpha$ but not $\beta$. A training sample used to train one set of weights may include one or more training samples, and the one or more training samples may have a same or similar parameter. Training samples used to train different sets of weights may correspond to different parameters, so that different sets of weights are applicable to sequences having different parameters. The training sample is, for example, a sequence obtained by performing an LDPC encoding on original data. For example, the first training data is any training sample used to train a specific set of weights, and the first training data may be a sequence obtained by performing an LDPC encoding on original data.

For example, the second apparatus performs the L iterations of decoding on the first training data by using one set of weights (referred to as the first weight set) corresponding to parameters of the first training data and by using the LDPC check matrix. In each iteration of decoding process of the L training, a weight corresponding to the current iteration of decoding in the first weight set may be used. The first weight set may include a weight corresponding to the L iterations of decoding. For example, it is understood as that the first weight set includes L subsets, where each subset is used for one iteration of decoding in the L iterations of decoding. For example, a subset corresponding to a specific iteration of decoding in the L iterations of decoding is referred to as a second weight, and the second weight may be used in the process of the current iteration of decoding.

S502. After the L iterations of decoding, if an obtained decoding result causes a loss function to meet a performance requirement, end training, to obtain the first weight set; or if an obtained decoding result fails to cause a loss function to meet a performance requirement, update the first weight set, and train second training data based on the updated first weight set, or retrain the first training data based on the updated first weight set.

After each iteration of decoding, the second apparatus may determine an obtained decoding result (for a process of obtaining the decoding result, refer to the embodiment shown in FIG. 2). If a decision result is 0, an iterative decoding on the first training data ends, and the decoding result is output; or if a decision result is not 0, and a quantity of times of iterative decoding is less than K, a next iteration of decoding may be performed on the first training data; or if a decision result is not 0, but a quantity of times of iterative decoding is K, the decoding is completed, and the decoding result is output. In this embodiment of this application, it is assumed that an actual quantity of times of iterative decoding of the first training data is L (in other words, when the quantity of times of iterative decoding is less than L, a decision result of the decoding result is not 0). Therefore, the second apparatus obtains the decoding result after the L iterations of decoding, and the decoding result is a decoding result output after completion of a last iteration of decoding in the L iterations of decoding. After outputting the decoding result, the second apparatus may determine whether the loss function meets the performance requirement. The loss function is, for example, a function between the original data corresponding to the training sample and a decoding result of the training sample. If the loss function meets the performance requirement, it indicates that decoding performance is good, and a training process may end. The second apparatus may record the first weight set, and the first weight set may be used as a set of the at least one set of weights. Alternatively, if the loss function does not meet the performance requirement, the second apparatus may update some or all weights in the first weight set, and retrain the first training data based on the updated first weight set, or retrain the second training data based on the updated first weight set, where the second training data and the first training data are used to train a same set of weights.

Optionally, the LDPC check matrix may be determined based on a circulant permutation matrix, and the circulant permutation matrix may be obtained by cyclically shifting an identity matrix based on a shift value. For example, a quantity of rows and a quantity of columns of the identity matrix are a first lifting size. For this, refer to the descriptions of the embodiment shown in FIG. 2.

Optionally, when the second apparatus decodes the first training data, connections in a same circulant permutation matrix in the LDPC check matrix correspond to a same weight. For this, refer to the descriptions of the embodiment shown in FIG. 2.

Optionally, when the second apparatus decodes the first training data, different circulant permutation matrices in the LDPC check matrix correspond to different weights. For this, refer to the descriptions of the embodiment shown in FIG. 2.

A row i and a column j of the LDPC check matrix correspond, for example, to a first index. Optionally, for the row i and the column j of the LDPC check matrix, different circulant permutation matrices corresponding to the first index correspond to a same weight. For this, refer to the descriptions of the embodiment shown in FIG. 2.

The embodiment shown in FIG. 5 describes a manner of obtaining, through training, the weight applied in the embodiment shown in FIG. 2. Therefore, optionally, the embodiment shown in FIG. 5 may be combined with the embodiment shown in FIG. 2, for example, a feature that the weight in the embodiment shown in FIG. 5 meets, may be a feature that the weight in the embodiment shown in FIG. 2 meets.

In embodiments of this application, the at least one set of weights may be obtained through training. If a quantity of the at least one set is greater than 1, one set of weights in the at least one set may be used in one round of decoding process (including multiple iterations of decoding), and different sets of weights may be used in different rounds of decoding processes. In different iterative decoding processes in one round of decoding process, different weights in one set of weights may also be used. In addition, if a quantity of weights corresponding to one iteration of decoding is greater than 1, different weights may also be used for different calculations even in a process of one iteration of decoding. It can be learned that in embodiments of this application, corresponding weights may be applied to different calculation processes during decoding, making the weights better match the corresponding calculation processes. Therefore, decoding flexibility is improved, and decoding performance is enhanced.

FIG. 6 is a diagram of a structure of a communication apparatus according to an embodiment of this application. The communication apparatus 600 may be the second apparatus or a circuit system of the second apparatus in the embodiment shown in any one of FIG. 2 or FIG. 5, and is configured to implement the method corresponding to the second apparatus in the foregoing method embodiments. Alternatively, the communication apparatus 600 may be the third apparatus or a circuit system of the third apparatus in the embodiment shown in any one of FIG. 2 or FIG. 5, and is configured to implement the method corresponding to the third apparatus in the foregoing method embodiments. For example, a circuit system is a chip system.

The communication apparatus 600 includes at least one processor 601. The processor 601 may be configured to perform internal processing of the apparatus to implement a specific control processing function. Optionally, the processor 601 includes instructions. Optionally, the processor 601 may store data. Optionally, different processors may be independent components, may be located at different physical locations, or may be located on different integrated circuits. Optionally, different processors may be integrated into one or more processors, for example, integrated into one or more integrated circuits.

Optionally, the communication apparatus 600 includes one or more memories 603 that is configured to store instructions. Optionally, the memory 603 may further store data. The processor and the memory may be separately disposed, or may be integrated together.

Optionally, the communication apparatus 600 includes a communication line 602 and at least one communication interface 604. Because the memory 603, the communication line 602, and the communication interface 604 are all optional, the memory 603, the communication line 602, and the communication interface 604 are all represented by dashed lines in FIG. 6.

Optionally, the communication apparatus 600 may further include a transceiver and/or an antenna. The transceiver may be configured to send information to another apparatus or receive information from another apparatus. The transceiver may be referred to as a transceiver, a transceiver circuit, an input/output interface, or the like, and is configured to implement a receiving and sending function of the communication apparatus 600 via the antenna. Optionally, the transceiver includes a transmitter (transmitter) and a receiver (receiver). For example, the transmitter may be configured to generate a radio frequency (radio frequency) signal based on a baseband signal, and the receiver may be configured to convert a radio frequency signal into a baseband signal.

The processor 601 may include a general-purpose central processing unit (central processing unit, CPU), a microprocessor, an application specific integrated circuit (application specific integrated circuit, ASIC), or one or more integrated circuits configured to control program execution of the solutions of this application.

The communication line 602 may include a path for transmitting information between the foregoing assemblies.

The communication interface 604 uses any apparatus like a transceiver, and is configured to communicate with another device or a communication network, for example, an Ethernet, a radio access network (radio access network, RAN), a wireless local area network (wireless local area network, WLAN), or a wired access network.

The memory 603 may be a read-only memory (read-only memory, ROM) or another type of static storage device that can store static information and instructions, a random access memory (random access memory, RAM) or another type of dynamic storage device that can store information and instructions, or may be an electrically erasable programmable read-only memory (electrically erasable programmable read-only memory, EEPROM), a compact disc read-only memory (compact disc read-only memory, CD-ROM) or another compact disc storage, an optical disc storage (including a compact disc, a laser disc, an optical disc, a digital versatile disc, a Bluray disc, or the like), a magnetic disk storage medium or another magnetic storage device, or any other medium that can be configured to carry or store expected program code in a form of an instruction or a data structure and that can be accessed by a computer, but is not limited thereto. The memory 603 may exist independently, and is connected to the processor 601 through the communication line 602. Alternatively, the memory 603 may be integrated with the processor 601.

The memory 603 is configured to store computer-executable instructions for executing the solutions of this application, and the processor 601 controls the execution. The processor 601 is configured to execute the computer-executable instructions stored in the memory 603, to implement the steps performed by the second apparatus or the third apparatus in the embodiment shown in any one of FIG. 2 or FIG. 5.

Optionally, the computer-executable instructions in embodiments of this application may also be referred to as application program code. This is not specifically limited in this embodiment of this application.

In a specific implementation, in an embodiment, the processor 601 may include one or more CPUs, for example, a CPU 0 and a CPU 1 in FIG. 6.

In a specific implementation, in an embodiment, the communication apparatus 600 may include a plurality of processors, for example, the processor 601 and a processor 605 in FIG. 6. Each of the processors may be a single-core (single-CPU) processor, or may be a multi-core (multi-CPU) processor. The processor herein may be one or more devices, circuits, and/or processing cores configured to process data (for example, computer program instructions).

When the apparatus shown in FIG. 6 is a chip, for example, a chip of the third apparatus or a chip of the second apparatus, the chip includes the processor 601 (where the chip may further include the processor 605), the communication line 602, and the communication interface 604. Optionally, the chip may include the memory 603. Specifically, the communication interface 604 may be an input interface, a pin, a circuit, or the like. The memory 603 may be a register, a cache, or the like. The processor 601 and the processor 605 may be a general-purpose CPU, a microprocessor, an ASIC, or one or more integrated circuits configured to control program execution of the method in any one of the foregoing embodiments.

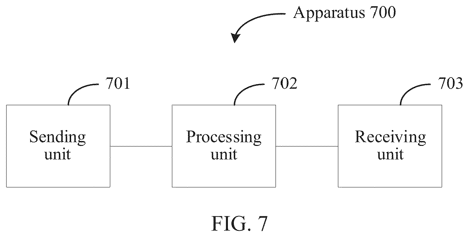

In embodiments of this application, the apparatus may be divided into functional modules based on the foregoing method examples. For example, each functional module may be obtained through division based on each corresponding function, or two or more functions may be integrated into one processing module. The integrated module may be implemented in a form of hardware, or may be implemented in a form of a software functional module. It should be noted that, in embodiments of this application, module division is an example, and is merely a logical function division. In actual implementation, another division manner may be used. For example, when each functional module is obtained through division based on each corresponding function, FIG. 7 is a diagram of an apparatus. The apparatus 700 may be the third apparatus or the second apparatus in the foregoing method embodiments, or a chip in the third apparatus or a chip in the second apparatus. The apparatus 700 includes a sending unit 701, a processing unit 702, and a receiving unit 703.

It should be understood that the apparatus 700 may be configured to implement the steps performed by the second apparatus or the third apparatus in the method provided in embodiments of this application. For related features, refer to the embodiment shown in any one of FIG. 2 or FIG. 5. Details are not described herein again.

Optionally, functions/implementation processes of the sending unit 701, the receiving unit 703, and the processing unit 702 in FIG. 7 may be implemented by the processor 601 in FIG. 6 invoking the computer-executable instructions stored in the memory 603. Alternatively, functions/implementation processes of the processing unit 702 in FIG. 7 may be implemented by the processor 601 in FIG. 6 invoking the computer-executable instructions stored in the memory 603, and the functions/implementation processes of the sending unit 701 and the receiving unit 703 in FIG. 7 may be implemented via the communication interface 604 in FIG. 6.

Optionally, when the apparatus 700 is a chip or a circuit, functions/implementation processes of the sending unit 701 and the receiving unit 703 may be implemented via a pin, a circuit, or the like.

This application further provides a computer-readable storage medium. The computer-readable storage medium stores a computer program or instructions. When the computer program or the instructions are run, the method performed by the second apparatus or the third apparatus in the foregoing method embodiments is implemented. In this way, the functions in the foregoing embodiments may be implemented in a form of a software functional unit and sold or used as an independent product. Based on such an understanding, the technical solutions of this application essentially, or the part contributing to conventional technologies, or a part of the technical solutions may be implemented in a form of a software product. The computer software product is stored in a storage medium, and includes several instructions for instructing a computer device (which may be a personal computer, a server, a network device, or the like) to perform all or a part of the steps of the methods described in embodiments of this application. The storage medium includes any medium that can store program code, such as a USB flash drive, a removable hard disk drive, a ROM, a RAM, a magnetic disk, or an optical disc.

This application further provides a computer program product. The computer program product includes computer program code. When the computer program code is run on a computer, the computer is caused to perform the method performed by the second apparatus or the third apparatus in any one of the foregoing method embodiments.

An embodiment of this application further provides a processing apparatus, including a processor and an interface. The processor is configured to perform the method performed by the second apparatus or the third apparatus in any one of the foregoing method embodiments.

All or some of the foregoing embodiments may be implemented by using software, hardware, firmware, or any combination thereof. When software is used to implement embodiments, all or some of embodiments may be implemented in a form of a computer program product. The computer program product includes one or more computer instructions. When computer program instructions are loaded and executed on a computer, the procedure or functions according to embodiments of this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk drive, a hard disk drive, or a magnetic tape), an optical medium (for example, a DVD), a semiconductor medium (for example, a solid-state drive, (solid-state disk, SSD)), or the like.

Various illustrative logical units and circuits described in embodiments of this application may implement or operate the described functions by using a general-purpose processor, a digital signal processor (digital signal processor, DSP), an ASIC, a field-programmable gate array (field-programmable gate array, FPGA) or another programmable logical apparatus, a discrete gate or transistor logic, a discrete hardware component, or a design of any combination thereof. The general-purpose processor may be a microprocessor. Optionally, the general-purpose processor may alternatively be any conventional processor, controller, microcontroller, or state machine. The processor may also be implemented by a combination of computing apparatuses, such as a digital signal processor and a microprocessor, a plurality of microprocessors, one or more microprocessors and a digital signal processor core, or any other similar configuration.

Steps of the methods or algorithms described in embodiments of this application may be directly embedded into hardware, a software unit executed by a processor, or a combination thereof. The software unit may be stored in a RAM, a flash memory, a ROM, an erasable programmable read-only memory (erasable programmable read-only memory, EPROM), an EEPROM, a register, a hard disk drive, a removable magnetic disk, a CD-ROM, or any other form of storage medium in the art. For example, the storage medium may be connected to the processor so that the processor can read information from the storage medium and write information to the storage medium. Alternatively, the storage medium may be integrated into a processor. The processor and the storage medium may be disposed in an ASIC, and the ASIC may be disposed in a terminal device. Optionally, the processor and the storage medium may be disposed in different parts of a terminal device.

These computer program instructions may also be loaded onto a computer or another programmable data processing device, so that a series of operations and steps are performed on the computer or the another programmable device, to generate computer-implemented processing. Therefore, the instructions executed on the computer or the another programmable device provide steps for implementing a specific function in one or more processes in the flowcharts and/or in one or more blocks in the block diagrams.

Mutual reference may be made to content in embodiments of this application. Unless otherwise specified or logical conflict occurs, terms and/or descriptions in different embodiments are consistent and may be mutually referenced, and technical features in different embodiments may be combined into a new embodiment based on an internal logical relationship between the technical features.

It may be understood that, in embodiments of this application, the second apparatus and/or the third apparatus may perform a part or all of steps in embodiments of this application. These steps or operations are merely examples. In embodiments of this application, other operations or variations of various operations may be further performed. In addition, the steps may be performed in a sequence different from that presented in embodiments of this application, and not all operations in embodiments of this application may be performed.

**Claims**

1. A decoding method, wherein the method comprises:

receiving a first sequence;
determining one set of weights from at least one set of weights based on a parameter of the first sequence, wherein the at least one set of weights is determined through training, the one set of weights comprises a weight corresponding to K iterations of decoding performed on the first sequence, there are at least two different weights in the one set of weights, a quantity of weights corresponding to one iteration of decoding in the K iterations of decoding is greater than or equal to 1, and K is a positive integer less than or equal to a maximum quantity of iterations of decoding; and
in a process of performing the one iteration of decoding in the K iterations of decoding on the first sequence, determining, based on the weight corresponding to the one iteration of decoding, information about N variable nodes and information about M check nodes corresponding to the first sequence, wherein both M and N are positive integers.

2. The method according to claim 1, wherein the weight corresponding to the one iteration of decoding comprises a first weight, the first weight is used to determine information about a first connection, and the first connection is a connection between one check node in the M check nodes and one variable node in the N variable nodes, wherein when the first weight is less than a first threshold, information about the one check node or information about the one variable node does not comprise the information about the first connection.

3. The method according to claim 1 or 2, wherein

in the process of the one iteration of decoding, the information about the N variable nodes and the information about the M check nodes are determined in a serial manner; or

the N variable nodes and the M check nodes belong to at least one group, each group comprises one or more variable nodes in the N variable nodes and/or comprises one or more check nodes in the M check nodes, and in the process of the one iteration of decoding, processing for any two groups in the at least one group is performed in a parallel manner, wherein when processing for one group is performed, information about a variable node and/or information about a check node in the group is determined in a serial manner.

4. The method according to claim 3, wherein
the at least one group is determined based on a low density parity check LDPC code check matrix, and each group in the at least one group comprises one or more rows of the LDPC check matrix, or comprises one or more columns of the LDPC check matrix, wherein one row of the LDPC check matrix corresponds to one check node in the M check nodes, and one column of the LDPC check matrix corresponds to one variable node in the N variable nodes.

5. The method according to any one of claims 1 to 4, wherein the method further comprises:

when a result of decision performed on the one iteration of decoding is 0, outputting the result of the one iteration of decoding, and ending the decoding; or

when a result of decision performed on the one iteration of decoding is not 0, performing a next iteration of decoding in the K iterations of decoding on the first sequence.

6. A parameter training method, wherein the method comprises:

performing L iterations of decoding on first training data by using an LDPC check matrix, and in a process of performing one iteration of decoding in the L iterations of decoding on the first training data, determining, based on a second weight, information about N variable nodes and information about M check nodes corresponding to the first training data, wherein the second weight belongs to a first weight set, the first weight set comprises a weight corresponding to the L iterations of decoding, the second weight corresponds to the one iteration of decoding, the second weight comprises one or more weights, L, N, and M are all positive integers, and L is a positive integer less than or equal to a maximum quantity of iterations of decoding; and

after the L iterations of decoding, if an obtained decoding result causes a loss function corresponding to the decoding result to meet a performance requirement, ending training, to obtain the first weight set, or if an obtained decoding result fails to cause a loss function corresponding to the decoding result to meet a performance requirement, updating the first weight set, and performing iterative decoding on second training data based on the updated first weight set.

7. The method according to claim 6, wherein the LDPC check matrix is determined based on a circulant permutation matrix, the circulant permutation matrix is obtained by cyclically shifting an identity matrix based on a shift value, and a quantity of rows of the identity matrix is a first lifting size.

8. The method according to claim 7, wherein the first lifting size is Zc.

9. The method according to claim 7, wherein in the one or more weights, connections in a same circulant permutation matrix correspond to a same weight, and connections in different circulant permutation matrices correspond to different weights.

10. The method according to claim 7 or 8, wherein row i and column j of the LDPC check matrix correspond to a first index, the first index corresponds to one or more values of the first lifting size, one of the values corresponds to one circulant permutation matrix, a weight corresponding to a first circulant permutation matrix corresponding to the first index comprises a weight corresponding to a second circulant permutation matrix corresponding to the first index, and a value of the first lifting size corresponding to the first circulant permutation matrix is greater than a value of the first lifting size corresponding to the second circulant permutation matrix.

11. A communication apparatus, comprising a control unit, a storage unit, and an LDPC decoding unit, wherein the control unit is separately connected to the memory and the LDPC decoding unit, wherein

the control unit is configured to: receive a first sequence, determine, based on a parameter of the first sequence, one set of weights from at least one set of weights stored in the storage unit, and input the one set of weights into the LDPC decoding unit, wherein the at least one set of weights is determined through training, the one set of weights comprises a weight corresponding to K iterations of decoding performed on the first sequence, there are at least two different weights in the one set of weights, a quantity of weights corresponding to one iteration of decoding in the K iterations of decoding is greater than or equal to 1, and K is a positive integer less than or equal to a maximum quantity of iterations of decoding; and

the LDPC decoding unit is configured to: receive the one set of weights, and in a process of performing the one iteration of decoding in the K iterations of decoding on the first sequence, determine, based on the weight corresponding to the one iteration of decoding, information about N variable nodes and information about M check nodes corresponding to the first sequence, wherein both M and N are positive integers.

12. The apparatus according to claim 11, wherein the weight corresponding to the one iteration of decoding comprises a first weight, the first weight is used to determine information about a first connection, and the first connection is a connection between one check node in the M check nodes and one variable node in the N variable nodes, wherein when the first weight is less than a first threshold, information about the one check node or information about the one variable node does not comprise the information about the first connection.

13. The apparatus according to claim 11 or 12, wherein

in the process of the one iteration of decoding, the information about the N variable nodes and the information about the M check nodes are determined in a serial manner; or

the N variable nodes and the M check nodes belong to at least one group, each group comprises one or more variable nodes in the N variable nodes and/or comprises one or more check nodes in the M check nodes, and in the process of the one iteration of decoding, processing for any two groups in the at least one group is performed in a parallel manner, wherein when processing for one group is performed, information about a variable node and/or information about a check node in the group is determined in a serial manner.

14. The apparatus according to claim 13, wherein the at least one group is determined based on an LDPC check matrix, and each group in the at least one group comprises one or more rows of the LDPC check matrix, or comprises one or more columns of the LDPC check matrix, wherein one row of the LDPC check matrix corresponds to one check node in the M check nodes, and one column of the LDPC check matrix corresponds to one variable node in the N variable nodes.

15. The apparatus according to any one of claims 11 to 14, wherein the control unit is further configured to:

when a result of decision performed on the one iteration of decoding is 0, output the result of the one iteration of decoding, and end the decoding; or

when a result of decision performed on the one iteration of decoding is not 0, perform a next iteration of decoding in the K iterations of decoding on the first sequence.

16. A communication apparatus, wherein the communication apparatus comprises a processing unit and a transceiver unit, and the processing unit is coupled to the transceiver unit, to perform the method according to any one of claims 1 to 5, or perform the method according to any one of claims 6 to 10.

17. A communication apparatus, wherein the communication apparatus comprises a processor and a memory, the memory is configured to store a computer program, and the processor is configured to execute the computer program stored in the memory, to cause the communication apparatus to perform the method according to any one of claims 1 to 5, or cause the communication apparatus to perform the method according to any one of claims 6 to 10.

18. A computer-readable storage medium, wherein the computer-readable storage medium is configured to store a computer program, and when the computer program is run on a computer, the computer is caused to perform the method according to any one of claims 1 to 5, or the computer is caused to perform the method according to any one of claims 6 to 10.

19. A computer program product, wherein the computer program product comprises a computer program, and when the computer program is run on a computer, the computer is caused to perform the method according to any one of claims 1 to 5, or the computer is caused to perform the method according to any one of claims 6 to 10.

20. A chip system, wherein the chip system comprises:
   a processor and an interface, wherein the processor is configured to invoke instructions from the interface and run the instructions, and when the processor executes the instructions, the method according to any one of claims 1 to 5 is implemented, or the method according to any one of claims 6 to 10 is implemented.

21. A communication system, comprising a second apparatus and a third apparatus, wherein

   the second apparatus is configured to perform the method according to any one of claims 1 to 5; and/or
   the third apparatus is configured to perform the method according to any one of claims 6 to 10.

```
┌─────────────────────┐        Sequence        ┌─────────────────────┐
│                     │ ──────────────────────▶ │  Second apparatus   │
│   First apparatus   │                         │     (decoding)      │
│                     │                         │                     │
└─────────────────────┘                         └─────────────────────┘
                                                           ▲
                                                           ┊
                                                           ┊ Weight
                                                           ┊
                                                ┌ ─ ─ ─ ─ ─┴─ ─ ─ ─ ─ ┐
                                                   Third apparatus
                                                │ (weight training)   │
                                                 ─ ─ ─ ─ ─ ─ ─ ─ ─ ─ ─
```

FIG. 1

```
┌───────────┐                          ┌───────────┐
│   First   │                          │  Second   │
│ apparatus │                          │ apparatus │
└───────────┘                          └───────────┘
      │        S201. First sequence          │
      │ ──────────────────────────────────▶ │
      │                                      │
      │              ┌───────────────────────────────────┐
      │              │  S202. Determine one set of       │
      │              │ weights from at least one set of  │
      │              │ weights based on a parameter      │
      │              │     of the first sequence         │
      │              └───────────────────────────────────┘
      │                                      │
      │              ┌───────────────────────────────────┐
      │              │      S203. In a process of        │
      │              │  performing one iteration of      │
      │              │   decoding in K iterations of     │
      │              │ decoding on the first sequence,   │
      │              │   determine, based on a weight    │
      │              │    corresponding to the one       │
      │              │      iteration of decoding,       │
      │              │ information about N variable      │
      │              │ nodes and information about M     │
      │              │ check nodes corresponding to      │
      │              │       the first sequence          │
      │              └───────────────────────────────────┘
      │                                      │
```

FIG. 2

FIG. 3

EP 4 718 731 A1

**FIG. 4**

A second apparatus performs L iterations of decoding on first training data by using an LDPC check matrix, and in a process of performing each iterations of decoding in the L iterations of decoding on the first training data, determines, based on a first weight set, information about N variable nodes and information about M check nodes corresponding to the first training data ⎯ S501

After the L iterations of decoding, if an obtained decoding result causes a loss function to meet a performance requirement, end training, to obtain the first weight set; or if an obtained decoding result fails to cause a loss function to meet a performance requirement, update the first weight set, and train second training data based on the updated first weight set ⎯ S502

**FIG. 5**

Communication apparatus 600

Processor 601

CPU 0

CPU 1

Processor 605

CPU 0

CPU 1

603

Memory

Communication line 602

604

Communication interface

**FIG. 6**

Apparatus 700

701 702 703

| Sending unit | Processing unit | Receiving unit |

FIG. 7

## INTERNATIONAL SEARCH REPORT

| International application No. |
| --- |
| **PCT/CN2024/097094** |

| A. | CLASSIFICATION OF SUBJECT MATTER |
| --- | --- |

H03M13/11(2006.01)i

According to International Patent Classification (IPC) or to both national classification and IPC

| B. | FIELDS SEARCHED |
| --- | --- |

Minimum documentation searched (classification system followed by classification symbols)

IPC:H03M

Documentation searched other than minimum documentation to the extent that such documents are included in the fields searched

Electronic data base consulted during the international search (name of data base and, where practicable, search terms used)

CNABS, CNTXT, VEN, USTXT, CNKI, IEEE: 译码, 解码, 权重, 变量节点, 校验节点, 连接, 串行, 分组, 矩阵, 迭代, 训练, decoding, weight, check node, variable node, connection, serial, group, matrix, iteration, train

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | WO 2019213947 A1 (QUALCOMM INC. et al.) 14 November 2019 (2019-11-14) description, paragraphs 105-108, 117-118, and 122-135 | 1-21 |
| A | CN 105846831 A (LENOVO (BEIJING) CO., LTD.) 10 August 2016 (2016-08-10) entire document | 1-21 |
| A | CN 109547032 A (SOUTH CHINA UNIVERSITY OF TECHNOLOGY) 29 March 2019 (2019-03-29) entire document | 1-21 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **18 August 2024** | **22 August 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/097094**

| Patent document cited in search report | | | Publication date (day/month/year) | Patent family member(s) | Publication date (day/month/year) |
|---|---|---|---|---|---|
| WO | 2019213947 | A1 | 14 November 2019 | None | |
| CN | 105846831 | A | 10 August 2016 | None | |
| CN | 109547032 | A | 29 March 2019 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310762257X

- CN 202311020949